# EUROPEAN PATENT APPLICATION

(11) **EP 4 481 821 A1**
(43) Date of publication of application: **25.12.2024**
(21) Application number: 23180735.5
(22) Date of filing: 21.06.2023
(51) Int. Cl.: H01L 27/092, H01L 21/761, H01L 29/10, H01L 29/40, H01L 29/423, H01L 29/78

(54) **SEMICONDUCTOR DIE WITH A VERTICAL TRANSISTOR DEVICE**

(71) Applicant: Infineon Technologies Austria AG, 9500 Villach (AT)
(72) Inventor: FERRARA, Alessandro, 9523 Villach (AT)
(74) Representative: Infineon Patent Department

(57) **Abstract**

The disclosure relates to a semiconductor die (1) with a semiconductor body (15), the semiconductor die (1) comprising a vertical transistor device (10), the vertical transistor device (10) having a source region (11) and a drain region (12) at opposite sides (15.1, 15.2) of the semiconductor body (15); the source region (11) and the drain region (12) made of a first doping type; the semiconductor die (1) further comprising a lateral transistor device (50), the lateral transistor device (50) having a source region (51) and a drain region (52) at the same side (15.1) of the semiconductor body (15); a body region (53) laterally between the source region (51) and the drain region (52); and a gate electrode (56); wherein the gate electrode (56) of the lateral transistor device (50) is disposed in a gate trench (59) laterally aside the body (53) region, and wherein the lateral transistor device (50) is disposed in a well region (60), the well (60) region made of a second doping type opposite to the first doping type.

## Description

### TECHNICAL FIELD

The present application relates to a semiconductor die comprising a vertical transistor device.

### BACKGROUND

The vertical transistor device has a source and a drain region, both made of a first doping type. The source and the drain region are arranged at opposite sides of a semiconductor body and the vertical current flow is for instance controlled by a gate region laterally aside a body region disposed in between.

### SUMMARY

It is an object of the present application to provide an advantageous semiconductor die with a vertical transistor device.

In addition to the vertical transistor device, the semiconductor die of claim 1 comprises a lateral transistor device which has its source and drain region at the same side of the semiconductor body. Laterally between, the body region of the lateral device is arranged, wherein its gate electrode is disposed in a gate trench aside the body region. In other words, though the channel of the lateral device extends laterally, its gate electrode is formed in a vertical trench. For a junction isolation, the lateral device is embedded into a well region made of a second doping type opposite to the source and drain doping of the vertical device.

The junction isolation can for instance allow for a simplified integration into a standard process, e. g. in comparison to a deep trench isolation between the vertical and lateral device. Depending on the implementation in detail, the well region can for example require only an additional implant or may be even formed in the same process step with a region of the vertical device, e. g. simultaneously with the body region of the vertical device. Similar considerations can apply for the gate electrode or gate region of the lateral device, the gate trench can for instance be etched simultaneously with a gate trench of the vertical device, see in detail below, e. g. only an additional gate recess is needed.

Particular embodiments and features are presented throughout this disclosure and in the dependent claims. Thereby, the individual features shall be disclosed independently of a specific claim category, the disclosure relates to apparatus and device aspects, but also to method and use aspects. If for instance a die manufactured in a specific way is described, this is also a disclosure of a respective manufacturing process, and vice versa. In general words, an approach of this application is to provide a vertical device, in particular vertical transistor device, and an additional device in the same semiconductor body, wherein the additional device is embedded into a well region forming a junction isolation, the additional device being in particular a lateral device, for instance lateral transistor device.

The lateral device can for example allow for an additional functionality, for instance be used to optimize the operational performance of the vertical device. Referring to a vertical device having its source region at the first side and its drain region at the second side of the semiconductor body, the lateral device can in particular be arranged at the first side as well, allowing for instance a wiring with the source and/or gate contacts of the vertical device. In other words, the source and drain region of the lateral device, as well as the source region of the vertical device, are arranged at the first side of the semiconductor body, whereas the drain region of the vertical device is arranged at the second side thereof. Typically, the first side is the frontside of the semiconductor body and the second side is the backside thereof.

"Vertical" or "vertically" refer to the vertical direction, which lies for instance perpendicular to a surface of the die, e. g. the surface of a substrate or an epitaxial layer formed on the substrate. "Above" means vertically aligned and closer to the first side or frontside of the die and "below" means vertically aligned and closer to the second side or backside. "Lateral" or "laterally" refer to the lateral directions perpendicular to the vertical direction, in which for instance the die area is taken.

The lateral device is disposed in the well region, e. g. embedded laterally and vertically downwards. Seen in a vertical cross-section, a boundary of the well region can for example embrace the device to both lateral sides and towards a portion of the semiconductor body below. Referring to a vertical distance taken from the first side of the semiconductor body, the well region can for instance even have a depth of only below 1 µm, in particular if manufactured simultaneously with the body region of the vertical device. For illustration, a lateral transistor device in a respectively shallow well region can for example have a breakdown voltage of less than 20 V, in particular less than 10 V. In other embodiments, however, the well region can have a vertical depth of 1-2 µm, enabling for example a breakdown voltage of 25 V or above. Of course, other breakdown voltages (and pwell depths) are possible depending on other circumstances and are contemplated by the present disclosure.

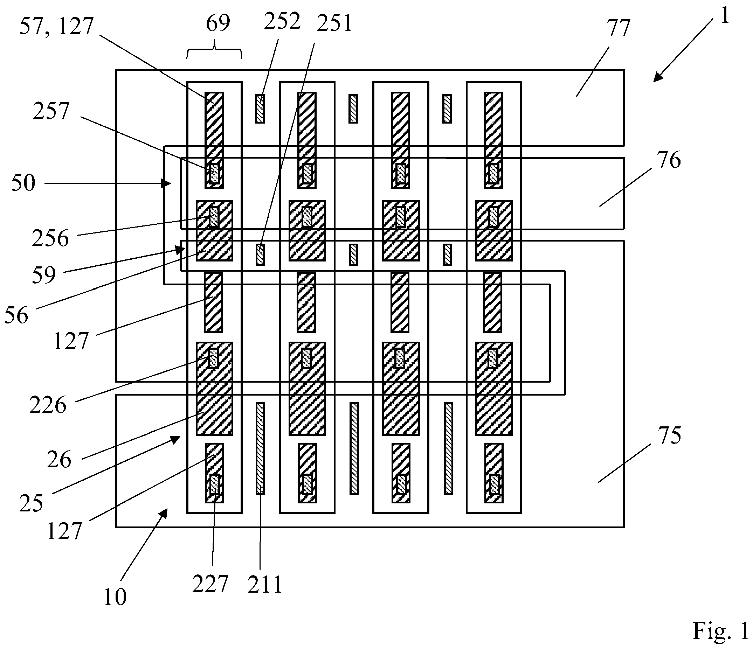

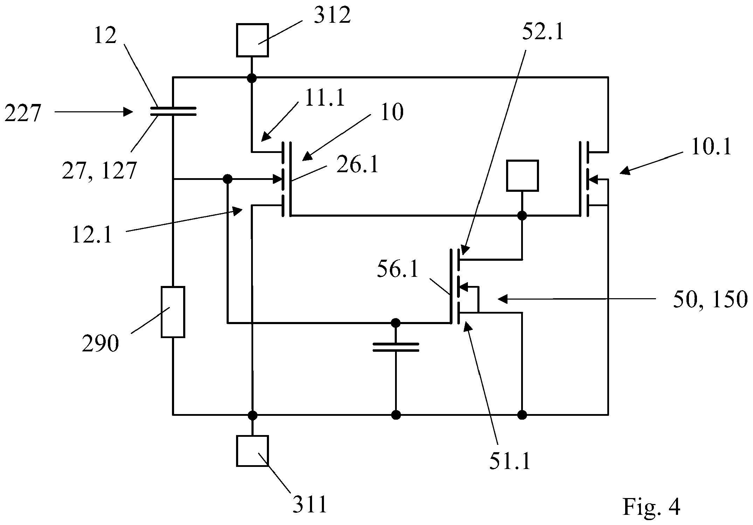

The source and the drain region of the vertical device are made of the first doping type and its body region is made of a second doping type opposite thereto. The source regions of the vertical and the lateral device can be on a same common potential, see figure 1 or 4 for illustration, or can also be on different electrical potentials. The vertical device can additionally comprise a drift region vertically between the body region and the drain region, made of the first doping type but with a lower doping concentration compared to its drain region. The well region, e. g. "first well region", is made of the second doping type opposite to the source and the drain region of the vertical device. It can form the junction isolation in particular towards a drift region of the vertical device, e. g. lie adjacent to this drift region. As mentioned, the well region can be made simultaneously with the body region of the vertical device (reuse of existing process steps). Alternatively, it can for instance be made in a separate implant step, the area of the well region being for example defined by an implant mask. Further alternatively, it can be made by an in-situ doped epitaxial deposition, e g. subsequent to a silicon etch in the respective area.

The source and the drain region of the lateral device can be made either of the first or the second doping type, see in detail below. For example, the first doping type is n-type and the second doping type is p-type. In other words, the vertical device can in particular be an NMOS which can be combined with a lateral NMOS or PMOS, wherein the well region is p-doped (and an additional n-doped well region is needed for the lateral PMOS). In an embodiment, the source and the drain region of the lateral device are made of the same doping type like the source and drain region of the vertical device, the lateral and vertical device being in particular NMOS devices. With the source and the drain region of the lateral device made of the first doping type, the well region made of the second doping type can in particular be the only well region required for the junction isolation.

In an embodiment, a portion of the well region forms the body region of the lateral device. In other words, the well region does not only provide for the junction insulation but extends between the source and the drain region of the lateral device. Alternatively, however, the body region of the lateral device can be made in an additional implant step, which can for example allow for a tuning of the threshold voltage of the lateral device. The body region of the lateral device can also be a combination, e. g. be an implantation on top of the well region implant, wherein the implantation on top can in particular be the body implantation of the vertical device (the same implantation step). The body region can also be a combination of a well of a second doping type, for instance the well region implant, with a first doping type implant which reduces the well doping, for instance to reduce the threshold voltage of the lateral device (or even achieve a negative threshold voltage, e. g. for a depletion mode FET, for example a JFET).

In particular embodiments, a second well region made of the first doping type is embedded into the well region made of the second doping type, wherein the lateral device is embedded into the second well region. In other words, the lateral device can be embedded into a plurality of well regions nested in each other. Generally, in this disclosure, when reference is made to the "well region" without further specification, this refers to the first well region made of the second doping type. The second well region can for instance expand the possibilities for the lateral device integration, e. g. enable a lateral PMOS.

The second well region can be manufactured in different ways and reference is made to the possibilities discussed above for the first well region, which can also be applied for the second well region. In particular, the nested well region can be obtained by making the first well region of a buried implant which does not reach up to the first side, in particular a buried p-well, in combination with a deep region or sinker implant which extends from the first side down to the buried implant. The buried implant forms a lower portion defining the well region downwards and the deep or sinker implant forms a rim portion defining it laterally. With the buried implant, the second well region above can in particular be the same as a drift region of the vertical device, resulting for instance from an in-situ doped epitaxial deposition, e. g. be obtained without a separate implant step.

Generally, a "gate region" can comprise a gate electrode and a gate dielectric, which applies for lateral and the vertical device. Likewise, a "field electrode region" comprises a field electrode and a field dielectric. Even though a planar gate is conceivable in general, the gate region of the vertical device can in particular be disposed in a gate trench, e. g. extending from the first side into the semiconductor body.

In a particular embodiment, the gate electrode of the vertical device disposed in the gate trench extends deeper into the semiconductor body than the gate electrode of the lateral transistor device. In other words, a lower end of the gate electrode of the vertical device is at a larger distance from the first side of the semiconductor body compared to a lower end of the gate electrode of the lateral device. A respectively shallow lateral gate electrode can for example interrupt a vertical current flow and prevent leakage currents between the lateral and vertical device.

Generally, the gate electrodes of the vertical and the lateral device can be disposed in different trenches. Nonetheless, these different trenches can be arranged in a common cell pattern, e. g. be translation symmetrical to each other. In a particular embodiment, however, the gate electrodes of the vertical and lateral device are disposed in different portions of a common continuous trench, e. g. isolated from each other by an insulating material, for instance silicon oxide. The integration in a common trench can for instance allow for an area optimization.

In an embodiment, the lateral transistor device comprises a drift region which can be made of the same doping type but have a lower doping concentration than the drain region of the lateral device. This drift region is disposed laterally between the body and the drain region of the lateral device, it can particularly be provided in combination with the lateral device having a field electrode for a field shaping in the drift region. In a particular embodiment, the gate electrode and the field electrode of the lateral device are disposed in the same gate trench, namely laterally aside each other in different portions of the gate trench, for instance electrically isolated by an insulating material in between, e. g. silicon oxide.

In general words, the drift region and field electrode can increase the breakdown voltage and/or decrease the on-resistance of the lateral device. The doping, length and thickness of the drift region can be chosen to sustain the required breakdown voltage, e. g. the voltage between gate and source of the vertical device in case of the pull-down application discussed below. In this case, by way of example, the lateral device can have a breakdown voltage between 25-35V, though a lower breakdown voltage can be sufficient in general. Independently of these details, the field electrode of the lateral device can be connected to a gate potential or in particular to a source potential, for example to the source region of the lateral device (e. g. isolated from the vertical source) or particularly to the source region of the vertical device.

The vertical device can in particular comprise a field electrode in a trench which extends into the drift region. In general, the gate and field electrodes of the vertical device can be disposed in different trenches, e. g. longitudinal trenches aside each other or in particular a spicular trench for the field electrode surrounded by a longitudinal trench for the gate electrode. In some embodiments, the field electrode is disposed in the longitudinal gate trench below the gate electrode of the vertical device, the field and gate electrode being for instance isolated from each other by an insulating material, e. g. silicon oxide.

In an embodiment, the field electrodes of the vertical and the lateral device are disposed in the same trench, namely in different portions of the same continuous trench. The field electrode of the vertical device can be disposed below the gate electrode of the vertical device in a first portion of the trench, wherein the gate and field electrode of the lateral device are disposed laterally aside each other in a second portion of the trench. In a particular embodiment, the field electrodes of the vertical and lateral device are made of the same continuous field electrode material, the field electrode material extending for instance from the first portion of the trench into the second portion. For example, over the whole lateral extension of the gate trench, e. g. in the first and second portion and in between, a lower portion of the gate trench can be filled with the same continuous field electrode material.

The field electrode material may form the field electrode of the vertical device in the first portion of the trench and the field electrode of the lateral device in the second portion of the trench. In an embodiment, the field plate material may reach upwards to the frontside in the second portion. In another embodiment, the field electrode material may not reach all the way upwards to the frontside in the second portion, but may for example only reach a bottom part of the gate trench of the lateral device, while the remaining part of the gate trench above the field plate material in the second portion may be filled with oxide.

In case the field electrode material reaches to the frontside (i.e., extends upwards), it can be used , e. g. to form a field electrode connection or to form the field electrode of the lateral device aside the drift region of the lateral device. In a particular embodiment, the field electrode material extends upwards in the common trench (to reach the frontside) at a position laterally between the gate electrodes of the vertical and the lateral transistor device.

In an embodiment, a buried doping layer is disposed below the well region. The buried doping layer does not necessarily lie directly adjacent to the well region, there can be a certain vertical distance in between. It can for instance be formed above or adjacent to the substrate, for example adjacent to the drain region of the vertical device extending below the lateral device as a common drain backside.

The buried doping layer can in particular be made of the same doping type like the drift region of the vertical device, for instance first doping type, in particular n-type. However, compared to the drift region, it can have a lower doping concentration. In case of a drift region with a doping profile, e. g. doping concentration varying over the vertical depth, the doping concentrations are compared on the same vertical height (at the same distance from the first side). Independently of these details, the buried doping layer can for instance increase the vertical breakdown voltage sustained below the well region to a value above the drain to source breakdown voltage of the vertical device, preventing for example a pre-maj or vertical breakdown.

The buried doping layer can for example be obtained by a second doping type implantation which results in a reduction of the first doping type concentration (but does not reverse it). This second doping type implantation can for instance be a p-implant introduced into a lightly doped n-layer which forms the drift region in the area of the vertical device, e. g. a lightly n-doped epitaxial layer. The second doping type implantation can for instance be a shallow implant prior to the growth of the epitaxial layer or layers, for instance combined with an anneal resulting in an upwards diffusion. Alternatively, the buried doping layer, in particular second doping type implant, can be implanted through the trench, e. g. obliquely through the gate trench prior to the electrode formation.

The body region of the vertical device can lie directly adjacent to the well region, in particular if the buried doping layer extends below the body region of the vertical device. Alternatively, however, the body region of the vertical device and the well region can be separated by a gap in between, e. g. an n-doped region. This can for instance allow for a separation of the source regions of the vertical and lateral devices, e. g. allow for different source potentials. The size of the gap can depend on the difference between the source potentials, e. g. be larger in case of a larger potential difference (to avoid a breakdown through the gap). Generally, the breakdown voltage of the lateral device can be smaller compared to the breakdown voltage of the vertical device, which can for instance be an advantage in high voltage applications, e. g. allow for a lateral or in particular pull-down device with a lower on resistance or smaller area.

In an embodiment, the lateral device is connected as a pull-down device between the gate electrode of the vertical device and the source region of the vertical device. The drain region of the lateral pull-down device is connected to the gate electrode of the vertical device, for instance via a metal line/route/interconnect (we would not do this connection directly at the pad) on the first side of the semiconductor body. In addition, the vertical device and the lateral pull-down device share a common source connection, their source regions being for instance connected by a metal pad or internal metal interconnect.

In case that the gate to source voltage of the vertical transistor device increased above the threshold voltage, an induced turn-on could result while the device should actually be in the off state. This can be prevented by the lateral pull-down device which can be in the on-state when vertical device is off or can be triggered during a fast-switching transient that would turn on the vertical device (causing for instance losses and potentially device failure). In such an event, the lateral pulldown device connects the gate electrode of the vertical device to the source region. For that purpose, the lateral pulldown device can generally be controlled externally, its gate electrode connected for instance via an extra terminal. Alternatively, it can be self-driven, see in detail below.

In an embodiment, the gate electrode of the lateral transistor device is connected to a field electrode disposed in a trench, e. g. locally at one end of the field electrode. At its laterally opposite end, the field electrode can for example be connected to the source domain. Consequently, the gate electrode can be connected to the source domain of the vertical device, namely via the resistance of the field electrode, and it can also be connected to the body region of the vertical device. By connecting the open end of the field electrode to the gate electrode, the field electrode can be used for probing a change in the backside potential which is for instance used to drive the gate of the pulldown transistor. This can in particular allow for sensing transients in the backside drain potential (e. g. due to the capacitive coupling between the open end of the field electrode and the common drain backside). The field electrode for sensing the transients can be the field electrode of the vertical or the lateral device, in particular the field electrode material extending in the lower portion over the whole length of the gate trench can be used for sensing.

In an embodiment, the field electrode used for sensing is disposed in a separate field electrode trench laterally aside the gate trench. This can for instance add a junction capacitance between the drain region of the vertical device and the lateral gate electrode, for example due to the gate of the lateral device connected not only to this field electrode but also to the body region aside the separate field electrode trench, increasing for example the driving strength because this capacitance is more non-linear (for the same voltage variation it can carry more current).

In an embodiment, the well region has a vertical doping profile, e. g. a doping concentration depending from the vertical depth. In particular, the doping concentration can be higher in a lower portion of the well region than in an upper portion thereof. The higher doping concentration in the lower portion, for instance buried p-well, can for instance moderate a snapback behavior of a parasitic bipolar, in particular npn, between the drain region of the vertical device and the drain region of the lateral device.

In an embodiment, a plurality of vertical transistor device cells are formed in the die. Seen in a vertical top view, the device cells can for instance have a polygonal shape, e. g. rectangular or quadratic shape, for instance with a needle shaped field electrode in each cell. Alternatively, the device cells can have a stripe-shape, the stripes having for example an elongated extension in a longitudinal direction and arranged with a translational symmetry in a transverse direction. Independently of these details, each vertical transistor device cell can in particular have a respective lateral device associated therewith, in particular disposed in the same common trench. Providing each device cell with a respective lateral device can for instance allow for a uniform switching behavior.

The application relates also to a method of manufacturing the semiconductor die disclosed here, comprising the steps of forming the vertical and lateral device as well as the well region. Regarding further details, reference is made to the description above. The drain and/or in particular source region of the lateral device can for instance be made of the same doping type, profile and/or depth like the source region of the vertical device, the regions can in particular be made simultaneously in the same process step. Alternatively, the drain and/or in particular source region of the lateral device can for instance extend deeper than the source region of the vertical device and be manufactured with a separate mask.

As mentioned, an approach of the application is to integrate an additional device in the same die with a vertical device and dispose the additional device in a well region. In addition to the lateral transistor device or in particular as an alternative thereto, a diode can be disposed in the well region, e. g. a lateral diode, its anode and cathode region disposed laterally aside each other. The diode can for instance be used for a temperature sensing.

To summarize, it shall also be disclosed: a semiconductor die with a semiconductor body, the semiconductor die comprising: a vertical transistor device, the vertical transistor device having: a source region and a drain region at opposite sides of the semiconductor body; the source region and the drain region made of a first doping type; the semiconductor die further comprising: a diode, the diode having: an anode contact and a cathode contact at the same (front) side of the semiconductor body; wherein the diode is disposed in a well region, the well region made of a second doping type opposite to the first doping type, and forming the anode region of the diode

The anode contact can for instance be connected to a metal pad via a p+-implant. The cathode contact can for instance be an n+-implant and can for example be connected via a shallow contact without a groove or just a shallow groove, wherein the n+-implantation can be done through this shallow contact.

### BRIEF DESCRIPTION OF THE DRAWINGS

Below, the semiconductor die with the vertical and the lateral devices and the manufacturing are explained in further detail by means of exemplary embodiments. Therein, the individual features can also be relevant in a different combination.
- Figure 1: shows a portion of a semiconductor die with a lateral and a vertical device in a top view;
- Figure 2: shows the vertical device in a cross-sectional view;
- Figure 3a: shows a vertical and a lateral transistor device sharing a common trench;
- Figure 3b: shows a cross-section along the trench of figure 3a;
- Figure 3c: shows a cross-section laterally aside the common trench of figure 3a;
- Figure 4: shows a circuit diagram with the vertical device and a lateral pull-down device connected thereto;
- Figure 5: shows a portion of a die with the vertical and the lateral device and illustrates another layout option;
- Figure 6: illustrates a further implantation option;
- Figure 7: shows a cross-section of a lateral device embedded into a second well region;
- Figure 8: illustrates an integration of a diode;
- Figure 9: summarizes some manufacturing steps in a flow diagram.

### DETAILED DESCRIPTION

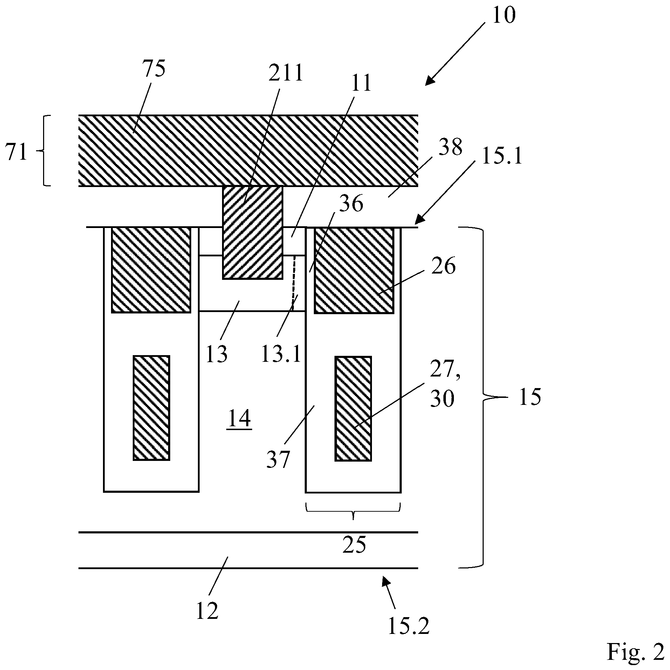

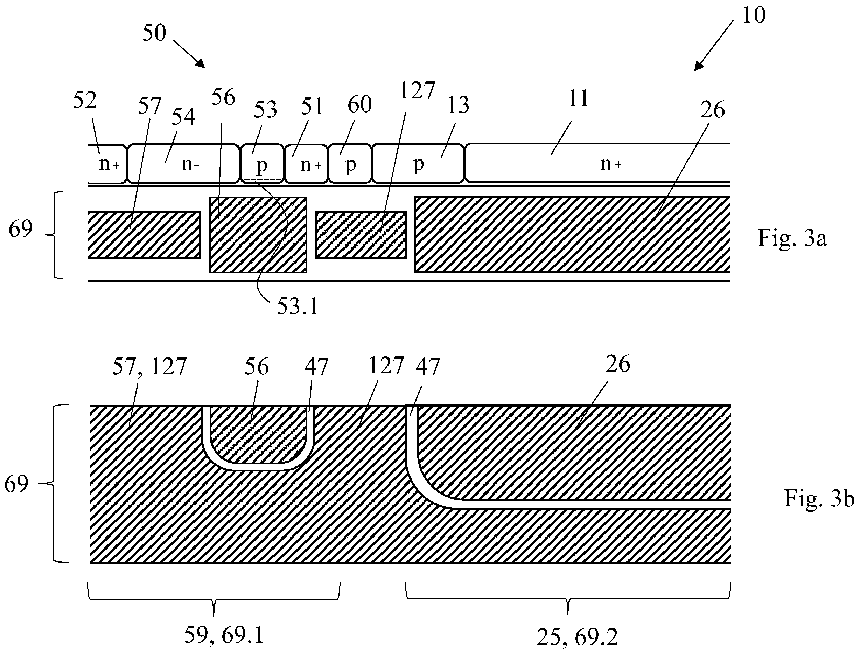

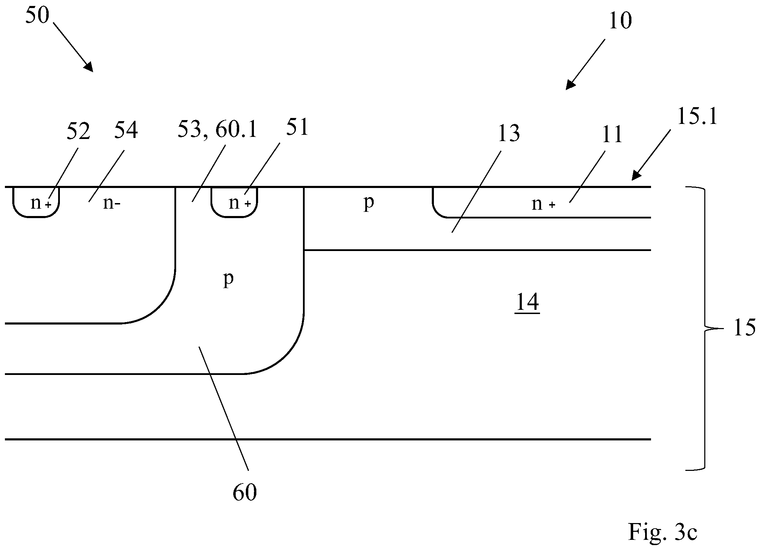

Figure 1 shows a portion of a semiconductor die 1 with a vertical transistor device 10 and a lateral transistor device 50. As explained with reference to figure 2 in further detail, the vertical device 10 has its source region 11 at a frontside of a semiconductor body, wherein the drain region is disposed at the backside not visible in figure 1. In case of the lateral device 50, its source region 51 and drain region 52 are both disposed at the frontside, see figures 3a/c in detail. A gate electrode 56 of the lateral device 50 is disposed in a gate trench 59 namely laterally aside a body region 53 of the lateral device 50 (shown in figure 3c in further detail). Though the gate electrode 56 is disposed in the gate trench 59, the channel extends laterally.

The gate electrode 26 of the vertical device 10 is disposed in a gate trench 25 as well, wherein the gate trench 59 of the lateral device 50 and the gate trench 25 of the vertical device 10 are different portions of a common continuous trench 69. The vertical device 10 comprises a field electrode 27 below the gate electrode 26 (figure 2), wherein the field electrode material 127 may extend up to the frontside locally, namely between the gate electrodes 26, 56 as well as at the laterally opposite ends of the common trench 69. At one end it is connected to the source domain, namely via a vertical interconnect 227 to a source metal pad 75. As discussed above, the field electrode material 127 may in some examples also not extend up to the frontside, but it may be covered with oxide.

The source regions of the vertical and lateral devices 10, 50 are both connected to the same source metal pad 75 via respective interconnects 211, 251. Via interconnects 256, 257 and the lateral gate metal pad 76, the gate electrode 56 of the lateral device 10 is connected to the field electrode material 127 for capacitively sensing backside transients, see in detail below. When the lateral device 50 is triggered, it connects the gate electrode 26 of the vertical device 10 to the drain domain of the lateral device 50, via the interconnects 226, 252 and the metal plate 77. The function of this wiring is discussed in further detail with the circuit diagram of figure 4.

Figure 2 shows a cross-sectional view of the vertical device 10, the sectional plane perpendicular to the longitudinal direction of the gate trench 25. Generally, in this disclosure, the like reference numerals are used for the like elements or elements having the like function and reference is also made to the description of the respectively other figures as well. Below the source region 11, the body region 13 is disposed. Laterally aside, the gate electrode 26 is disposed in the gate trench 25, capacitively coupling to the body region 13 via a gate dielectric 36 to form a channel 13.1. The channel 13.1 extends vertically aside the gate trench 25, below a drift region 14 and a drain region 12 are disposed. In the example shown, the source, drain and drift regions 11, 14, 12 are n-doped, whereas the body region 13 is p-doped.

The gate trench 25 extends from a first side 15.1 of the semiconductor body 15 down into the drift region 14. Below the gate electrode 26, a field electrode 27 is disposed in the gate trench 25, isolated from the drift region 14 and the gate electrode 26 by an insulating material 37. On the frontside 15.1, the source metal pad 75 is disposed, electrically isolated from the semiconductor body 15 by an insulating layer 38. The source metal pad 75 is formed in a metallization layer 71, in which the other metal pads shown in figure 1 are formed as well. Even though only a single metallization layer is shown in this exemplary embodiment, a stack with more than one metallization layer could also be provided.

Figures 3a-c illustrate in particular the lateral device 50, in a top view in figure 3a and in cross-sectional views in figures 3b/c. The top view illustrates the common continuous trench 69, wherein the lateral device 50 is disposed in a first portion 69.1 thereof (fig. 3b), also referred to as gate trench 59 of the lateral device 50. Aside the gate trench 59, the source region 51, body region 53 and drain region 52 are disposed, with a drift region 54 between the body region 53 and drain region 52. In the example shown, the body region 53 is p-doped and that the other regions are n-doped. Even though the gate electrode 56 is disposed in the gate trench 59, the channel region 53.1 formed aside in the body region 53 extends laterally.

In the same gate trench 59, laterally aside the gate electrode 56 and isolated therefrom, the field electrode 57 is disposed, capacitively coupling to the drift region 54. In a second portion 69.2 of the common continuous trench 69, the gate electrode 26 of the vertical device 10 is disposed, laterally aside the source region 11 is formed.

Figure 3b shows a cross section through the common continuous trench 69 in which the gate electrodes 26, 56 are disposed. They are electrically isolated from each other by an insulating material 47, silicon oxide in the example shown. The gate electrode 26 extends deeper than the gate electrode 56. Below the gate electrode 26, the field electrode 27 made of a field electrode material 127 is disposed. The field electrode material 127 extends continuously in a lower portion of the common continuous trench 69, e. g. below the gate electrode 56 and laterally aside. In between the gate electrodes 26, 56, the field electrode material 127 can reach up to the first side 15.1 of the semiconductor body 15. This applies also for the other side of the gate electrode 56, where the field electrode material 127 forms the field electrode 57 of the lateral device 50. In the example shown, the field electrode material 127 is polysilicon.

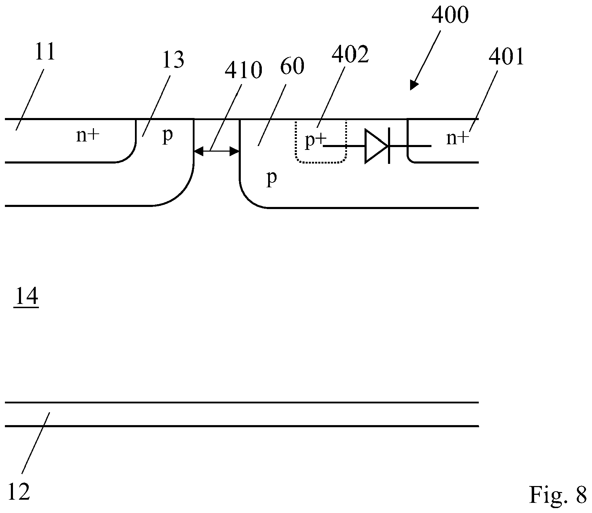

The cross-sectional plane of figure 3c lies parallel to the one of figure 3b, but aside the trench in the semiconductor body 15. The lateral device 50 is embedded into a well region 60 made of a second doping type which is p-type in this example. The well region 60 forms a junction isolation, it lies adjacent to the drift region 14. Above, it lies adjacent to the body region 13 which reaches up to the first side 15.1 aside the source region 11. In an alternative embodiment, the well region 60 and body region 13 can be spaced from each other by a gap (see figure 8 for illustration). The doping can also be done in reverse to the indication in figure 3c, such that a vertical PMOS would be combined with a lateral PMOS.

The circuit diagram of figure 4 illustrates the vertical device 10 with the lateral device 50 connected as a pull-down device 150. A drain contact 52.1 of the lateral device 50 connects to the gate contact 26.1 of the vertical device 10 and the source contact 51.1 connects to the source domain 311. The gate contact 56.1 of the lateral device 50 is connected to the open end of the field electrode 27 or field electrode material 127 (via the metal pad 76 in figure 1, see the remarks above). The field electrode 27 or field electrode material 127 forms one capacitor electrode of a capacitor 227, the other capacitor electrode is formed by the drain region 12.

Via the capacitor 227, transients in the backside or drain potential can be sensed. For instance in case of an increasing drain potential, the capacitor 227 is charged and, in consequence, the gate electrode 56 of the lateral device 50 is charged as well. The pulldown device 150 is switched into the conducting state and connects the gate contact 26.1 of the vertical device 10 to the source domain 311. In the like manner, the pulldown device 150 connects to another vertical device or device cell 10.1 which is connected in parallel to the vertical device 10 between the source and the drain and domain 311, 312. The only difference is that the field plate of the device cell 10.1 is not used for sensing the drain potential, but is directly connected to the source domain 311

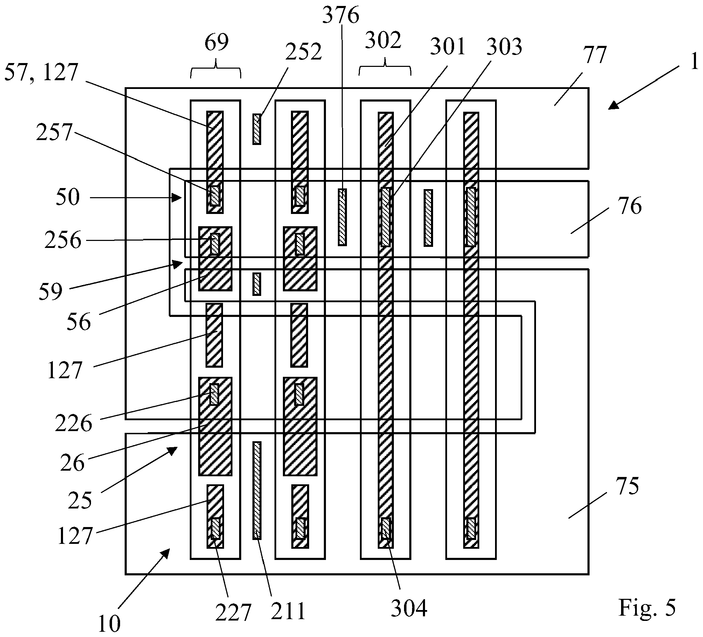

Figure 5 shows an embodiment with some amendments compared to figure 1. Like in figure 1, the vertical and the lateral device 10, 50 are formed with their gate and field electrodes 26, 56; 27, 57 in the same continuous trench 69. In this respect, the layout of figure 5 differs only in that the interconnect 257 which connects in figure 1 the open end of the field electrode to the gate domain of the lateral device 50 is omitted in figure 5. Instead, the gate electrode 56 is connected to a separate field electrode 301 in a separate trench 302. This connection is formed by the vertical interconnects 256, 303 and via the lateral gate metal pad 76. Thus, in comparison to figure 1, not the field electrodes or field electrode material of the devices 10, 50 is used for sensing backside transients, but a separate field electrode 301 is provided for that purpose (in figure 5 a second sensing field electrode is shown and connected in the like manner, but not referenced in further detail).

Via an interconnect 376, a body region adjacent to the separate trench 302 is connected to the metal pad 76, namely to the gate electrode 56 of the lateral device 50. This connection of the gate electrode 56 adds the capacitance between the body region and the drift region below in parallel to the capacitance of the field electrode 301. This can give a more non-linear capacitance (stronger driving strength).

At its opposite end, namely at the lower end in figure 5, the field electrode 301 is connected to the source metal pad 75 via the interconnect 304, which gives the source connection via the field plate resistance 290 referenced in figure 4.

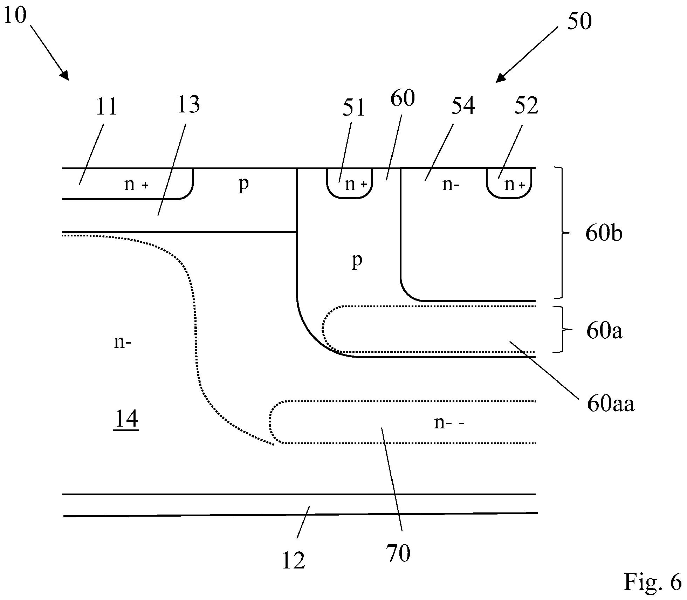

Figure 6 shows a cross-sectional view comparable to figure 3c to which reference is made as regards the doping regions of the vertical and lateral device 10, 50. Figure 6 illustrates additionally a buried doping layer 70 disposed below the well region 60, for instance on the substrate or drain region 12. The buried doping layer 70 is made of the first doping type like the drift region 14, which is n-type in the example shown, but has a lower doping concentration compared to the drift region 14.

Additionally, a doping concentration of the well region 60 is higher in a lower portion 60a of the well region 60 than in an upper portion 60b. In the example shown, this results from a deep buried implant 60aa, namely deep buried p-implant.

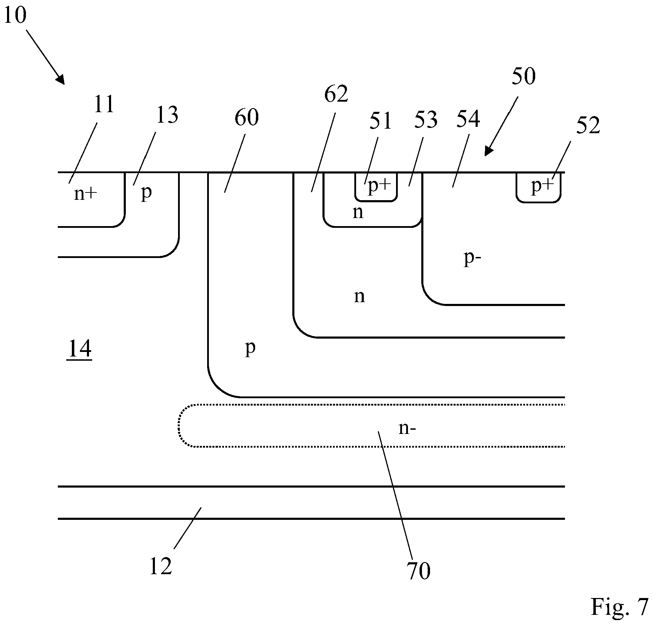

Figure 7 illustrates yet another embodiment, wherein reference is made to the description above as regards the vertical device 10. The lateral device 50 of figure 7 is a PMOS, its source and drain region 51, 52 being p-doped, while the vertical device 10 still is a NMOS. The body region 53 is n-doped, wherein a lightly p-doped drift region 54 is disposed between the body region 53 and the drain region 52. In the first well region 60 made of the second doping type, p-type in this example, a second well region 62 is disposed. The lateral device 50, namely PMOS, is embedded into the second well region 62 made of the first doping type which is n-type in the example shown. Alternatively, the doping could be inversed, e. g. a vertical PMOS combined with a lateral NMOS.

Figure 8 illustrates the integration of a diode 400 into the well region 60. A cathode contact 401 is formed by an n-implant region, wherein the well region 60 itself or in particular an additional p+-implant forms the anode contact 402. The diode 400 can for instance be used for temperature sensing, it can have a comparably low breakdown voltage (e. g. significantly below 10 V). In this case, the well region 60 is made without a higher doping concentration in a lower portion and can be made at the same time as the body region of the lateral device (without extra process steps), the deep buried implant discussed above can be omitted. In comparison to the embodiment of fig. 3c, the source, body, drift and drain regions 11, 13, 14, 12 remain unchanged, which can also apply for the well region 60 and the region 52.

The well region 60 is laterally spaced from the vertical device 10, namely its body region 13, by a gap 410. Consequently, the anode contact 402 of the diode 400 is separated from the source region 11. For example, a p+ region may be formed as the anode contact 402 in the well region 60 In an alternative embodiment not shown, the gap 410 can be omitted, the anode contact 402 of the diode being in contact with the body region 13 (shared with the body diode of the vertical device).

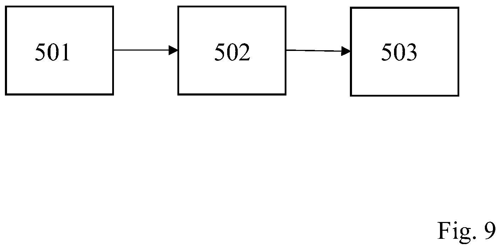

Figure 9 summarizes some manufacturing steps, namely a forming 501 of the vertical device 10, a forming 502 of the well region 60 and a forming 503 of the lateral device 50. The schematic drawing of figure 9 shall not imply a chronological sequence of the steps, they can overlap or be conducted simultaneously, see in detail above.

## Claims

1. A semiconductor die (1) with a semiconductor body (15),
the semiconductor die (1) comprising:
a vertical transistor device (10), the vertical transistor device (10) having:
a source region (11) and a drain region (12) at opposite sides (15.1, 15.2) of the semiconductor body (15);
the source region (11) and the drain region (12) made of a first doping type;
the semiconductor die (1) further comprising:
a lateral transistor device (50), the lateral transistor device (50) having:
a source region (51) and a drain region (52) at the same side (15.1) of the semiconductor body (15);
a body region (53) laterally between the source region (51) and the drain region (52); and
a gate electrode (56);
wherein the gate electrode (56) of the lateral transistor device (50) is disposed in a gate trench (59) laterally aside the body (53) region,
and wherein the lateral transistor device (50) is disposed in a well region (60),
the well (60) region made of a second doping type opposite to the first doping type.

2. The semiconductor die (1) of claim 1, wherein the source region (51) and the drain region (52) of the lateral transistor device (50) are made of the first doping type.

3. The semiconductor die (1) of claim 2, wherein a portion (60.1) of the well region extends between the source region (51) and the drain region (52) of the lateral transistor device (50) and forms the body region (53) of the lateral transistor device (50).

4. The semiconductor die (1) of claim 1, additionally comprising:
a second well region (62) made of the first doping type and embedded into the well region (60);
wherein the body region (53) of the lateral transistor device (50) is made of the first doping type.

5. The semiconductor die (1) of any one of the preceding claims, wherein a gate electrode (26) of the vertical transistor device (10) is disposed in a gate trench (25) and extends deeper into the semiconductor body (15) than the gate electrode (56) of the lateral transistor device (50).

6. The semiconductor die (1) of any one of the preceding claims, wherein a gate electrode (26) of the vertical transistor device (10) is disposed in a gate trench (25), the gate trench (25) of the vertical transistor device (10) and the gate trench (59) of the lateral transistor device (50) being different portions (69.1, 69.2) of a common continuous trench (69).

7. The semiconductor die (1) of any one of the preceding claims, the lateral transistor device (50) additionally comprising:
a drift region (54) made of the same doping type like the drain region (52) of the lateral transistor device (50); and
a field electrode (57) laterally aside the drift region (54) and disposed with the gate electrode (56) in the gate trench (59) of the lateral transistor device (50).

8. The semiconductor die (1) of claims 6 and 7, the vertical transistor device (10) additionally comprising:
a field electrode (27) made of a field electrode material (127) and disposed in the gate trench (25) of the vertical transistor device (10) below the gate electrode (26) of the vertical transistor device (10);
wherein the field electrode (57) of the lateral transistor device (50) is made of the same continuous field electrode material (127) like the field electrode of the vertical device (10); and/or
the field electrode material (127) extends upwards in the common trench (69) to a position laterally between the gate electrode (26) of the vertical transistor device (10) and the gate electrode (56) of the lateral transistor device (50).

9. The semiconductor die (1) of any one of the preceding claims, additionally comprising:
a buried doping layer (70) disposed vertically below the well region (60);
the buried doping layer (70) made of the first doping type like a drift region (14) of the vertical device but having a lower doping concentration compared to the drift region (14).

10. The semiconductor die (1) of any one of the preceding claims, wherein the lateral transistor device (50) is connected as a pull-down device (150) between a gate electrode (25) of the vertical transistor device (10) and the source region (11) of the vertical transistor device (10).

11. The semiconductor die (1) of any one of the preceding claims, wherein the gate electrode (56) of the lateral transistor device (50) is connected to a field electrode (27, 127, 301) disposed in a trench, the field electrode (27) disposed in particular below a gate electrode (26) of the vertical transistor device (10) in a gate trench (25) of the vertical transistor device (10) and/or together with the gate electrode (56) of the lateral transistor device (50) in a common continuous trench (69).

12. The semiconductor die (1) of claim 11, wherein the field electrode (301) is disposed in a separate field electrode trench (302) laterally aside the gate trench (59) of the lateral transistor device (50).

13. The semiconductor die (1) of any one of the preceding claims, wherein a doping concentration of the well region (60) is higher in a lower portion (60a) than in an upper portion (60b).

14. The semiconductor die (1) of any one of the preceding claims, comprising:
a plurality of vertical transistor device cells (10.1);
wherein each vertical transistor device cell (10.1) has a respective lateral device (50) associated therewith.

15. A method of manufacturing the semiconductor die (1) of any one of the preceding claims, the method comprising:
- forming the vertical transistor device (10);
- forming the well region (60);
- forming the lateral transistor device (50).

## Amended claims

### Amended claims in accordance with Rule 137(2) EPC.

1. A semiconductor die (1) with a semiconductor body (15), the semiconductor die (1) comprising:
a vertical transistor device (10), the vertical transistor device (10) having:
a source region (11) and a drain region (12) at opposite sides (15.1, 15.2) of the semiconductor body (15), the source region (11) and the drain region (12) made of a first doping type; and
a lateral transistor device (50), the lateral transistor device (50) having:
a source region (51) and a drain region (52) at the same side (15.1) of the semiconductor body (15);
a body region (53) laterally between the source region (51) and the drain region (52); and
a gate electrode (56), wherein the gate electrode (56) of the lateral transistor device (50) is disposed in a gate trench (59) laterally aside the body (53) region, and
wherein the lateral transistor device (50) is disposed in a well region (60), the well (60) region made of a second doping type opposite to the first doping type.

2. The semiconductor die (1) of claim 1, wherein the source region (51) and the drain region (52) of the lateral transistor device (50) are made of the first doping type.

3. The semiconductor die (1) of claim 2, wherein a portion (60.1) of the well region extends between the source region (51) and the drain region (52) of the lateral transistor device (50) and forms the body region (53) of the lateral transistor device (50).

4. The semiconductor die (1) of claim 1, additionally comprising:
a second well region (62) made of the first doping type and embedded into the well region (60);
wherein the body region (53) of the lateral transistor device (50) is made of the first doping type.

5. The semiconductor die (1) of any one of the preceding claims, wherein a gate electrode (26) of the vertical transistor device (10) is disposed in a gate trench (25) and extends deeper into the semiconductor body (15) than the gate electrode (56) of the lateral transistor device (50).

6. The semiconductor die (1) of any one of the preceding claims, wherein a gate electrode (26) of the vertical transistor device (10) is disposed in a gate trench (25), the gate trench (25) of the vertical transistor device (10) and the gate trench (59) of the lateral transistor device (50) being different portions (69.1, 69.2) of a common continuous trench (69).

7. The semiconductor die (1) of any one of the preceding claims, the lateral transistor device (50) additionally comprising:
a drift region (54) made of the same doping type like the drain region (52) of the lateral transistor device (50); and
a field electrode (57) laterally aside the drift region (54) and disposed with the gate electrode (56) in the gate trench (59) of the lateral transistor device (50).

8. The semiconductor die (1) of claims 6 and 7, the vertical transistor device (10) additionally comprising:
a field electrode (27) made of a field electrode material (127) and disposed in the gate trench (25) of the vertical transistor device (10) below the gate electrode (26) of the vertical transistor device (10);
wherein the field electrode (57) of the lateral transistor device (50) is made of the same continuous field electrode material (127) like the field electrode of the vertical device (10).

9. The semiconductor die (1) of any one of the preceding claims, additionally comprising:
a buried doping layer (70) disposed vertically below the well region (60);
the buried doping layer (70) made of the first doping type like a drift region (14) of the vertical device but having a lower doping concentration compared to the drift region (14).

10. The semiconductor die (1) of any one of the preceding claims, wherein the lateral transistor device (50) is connected as a pull-down device (150) between a gate electrode (25) of the vertical transistor device (10) and the source region (11) of the vertical transistor device (10).

11. The semiconductor die (1) of any one of the preceding claims, wherein the gate electrode (56) of the lateral transistor device (50) is connected to a field electrode (27, 127, 301) disposed in a trench, the field electrode (27) disposed in particular below a gate electrode (26) of the vertical transistor device (10) in a gate trench (25) of the vertical transistor device (10) and/or together with the gate electrode (56) of the lateral transistor device (50) in a common continuous trench (69).

12. The semiconductor die (1) of claim 11, wherein the field electrode (301) is disposed in a separate field electrode trench (302) laterally aside the gate trench (59) of the lateral transistor device (50).

13. The semiconductor die (1) of any one of the preceding claims, wherein a doping concentration of the well region (60) is higher in a lower portion (60a) than in an upper portion (60b).

14. The semiconductor die (1) of any one of the preceding claims, comprising:
a plurality of vertical transistor device cells (10.1);
wherein each vertical transistor device cell (10.1) has a respective lateral device (50) associated therewith.

15. A method of manufacturing the semiconductor die (1) of any one of the preceding claims, the method comprising:
- forming the vertical transistor device (10);
- forming the well region (60);
- forming the lateral transistor device (50).
